Europäisches Patentamt

(19) European Patent Office

Office européen des brevets

(11) Publication number: **0 443 841 A2**

# (12) EUROPEAN PATENT APPLICATION

(21) Application number: **91301363.7**

(51) Int. Cl.⁵: **H01L 23/14**

(22) Date of filing: **20.02.91**

(30) Priority: **21.02.90 US 483050**

(43) Date of publication of application:
**28.08.91 Bulletin 91/35**

(84) Designated Contracting States:
**AT BE CH DE DK ES FR GB GR IT LI LU NL SE**

(71) Applicant: **JOHNSON MATTHEY PUBLIC
LIMITED COMPANY
78 Hatton Garden
London, EC1N 8JP (GB)**

(72) Inventor: **Nguyen, My N.
12517 Montero Place
San Diego, California 92128 (US)**

(74) Representative: **Wishart, Ian Carmichael et al
Patents Department Johnson Matthey
Technology Centre Blounts Court Sonning
Common
Reading, Berks RG4 9NH (GB)**

(54) Silver-filled die attach compositions and use of same.

(57)  A paste composition for die attachment comprising silver flake having a surface area between 0.4-1.3 m²/g and a tap density of from 2.5-4.0 g/cc; a polyimide siloxane; and a liquid vehicle having a boiling point in the range of 120-220°C.

EP 0 443 841 A2

# SILVER-FILLED DIE ATTACH COMPOSITIONS AND USE OF SAME

## Background of the Invention

The invention is concerned with novel silver-filled bonding compositions which are useful, for example, in attaching semi-conductor elements such as silicon dies or IC chips to metal lead frames in plastic packages.

Conventional die bonding materials or pastes usually comprise one or more resinous components, e.g. epoxies or polyimides which are filled with precious metals, usually gold or silver, and a liquid vehicle. While such compositions are useful and have certain distinct advantages, they suffer from several disadvantages. These include high stress imparted on the die, poor thermal stability and outgassing. The high stress is due to thermal expansion mismatches between the die, the metal lead frame and the bonding material as well as the high rigidity of the adhesive which transmits thermally induced stress to the die.

With die sizes becoming larger, the above problems are substantially magnified thus causing package unreliability problems including failure induced by mechanical stress and/or moisture.

## Summary of the Invention

The principle object of the present invention is to provide pastes or compositions which obviate or minimize the problems referred to above.

Briefly described, the present pastes comprise the following essential components :

1. silver flake having a surface area between 0.4-1.3 m$^2$/g and a tap density of from 2.5-4.0 g/cc ;
2. a polyimide siloxane ; and
3. a liquid vehicle or solvent with a boiling point in the range of 120-220°C.

According to the invention, the silver flake should comprise from about 50-90%, preferably at least 70%, of the total weight of the paste composition.

Polyimide siloxanes for use herein are commercially available and well known in the art. See, for example, U.S. Patents 4,829,131 ; 4,558,110 ; 4,586,997 and 4,670,497, the disclosures thereof being incorporated herein by reference. Of the available polyimide siloxanes, a preferred polyimide siloxane for use herein is that known as "Oxysim" (Occidental Chemical Corp.). This is a block copolymer consisting of "hard" imide segments and "soft" siloxane segments. As a result, the material has a lower modulus than conventional polyimide and lower moisture content. In addition, the material is fully imidized and soluble with a glass transition temperature (Tg) greater than 200°C. The high glass transition is desirable in order to meet certain package reliability tests. Two available "Oxysim" products are identified as "Oxysim" 2020M and "Oxysim" 2030M. The first of these has a Tg of 220°C and contains 39% siloxane while the other (2030M) is disclosed as having a Tg of 260°C with a 25% siloxane content.

A variety of vehicles or diluents may be used herein. These include, as examples, acetophenone, diglyme, triglyme, 1-methyl 2-pyrrolidinone (NMP), acetyl acetone, mixtures of these and/or equivalents thereof. It is noted that U.S. Patent 4,829,131 refers to the polyimide siloxanes disclosed therein as soluble in diglyme and useful in the micro-electronics industry.

The amounts of polyimide siloxane and vehicle which are used may be varied fairly widely. Typically, however, the polyimide siloxane will comprise 7-20%, preferably 10-20%, by weight of the paste with the balance, apart from the silver flake, being essentially vehicle.

It has been found that the paste or attach compositions of the invention result in reduced die stress, for example, one-tenth of the stress obtained using other conventional materials. See Table II hereinafter. The compounds also provide high die shear strength at a test temperature of 175°C (see Table I) and low moisture and ionic contaminants.

## Detailed Description of the Invention

One preferred paste according to the invention comprises the following :

A

```
        silver flake
(0.4-1.3 m²/g surface area,
  2.5-4.0 g/cc tap density)              74%

        Oxysim 2020M                      11%

        Diglyme                           15%
```

The composition may be prepared in any convenient fashion, for example, by simply mixing the three components together simultaneously or by adding the polyimide siloxane to the vehicle followed by addition of the silver flake.

Other representative formulations include the following :

B

```
silver flake              53.1
triglyme                  28.5
NMP                        9.4
Sim 2030M                  9.0

                         100.0
```

C

```
silver flake              53.1
acetophenone              37.9
Sim 2030M                  9.0

                         100.0
```

In use, the paste is placed on the lead frame at the desired location and the IC or die positioned thereon. Conventionally, the resulting package is then fed on a belt through a furnace where the package is heated to complete the bonding. The heating is carried out gradually to avoid gassing and voiding, the temperature being raised at a rate of 10-20°C/minute in the furnace to about 200-250°C. The composite is maintained at this temperature for about 20-30 minutes to be certain that solvent or vehicle is removed completely. No curing or further heat treatment is required to complete the attachment.

The results of die shear tests using composition A to attach dies of various sizes are shown in Table I. These results were obtained following the heating procedure outlined above to bond the die to the lead frame. A temperature of about 220°C was used for the final heating stage.

TABLE I

DIE SHEAR TESTS

| Die Size MIL | Die Shear at 25 C KG | Die Shear at 175 C KG |
|---|---|---|
| 50 x 50 | 2.0 | 1.0 |
| 100 x 100 | 2.8 | 1.5 |
| 250 x 250 | > 5.2 | 2.0 |

Table II compares the die stress for a die attachment using the present paste (composition A) against the die stress for the same attachment using a paste based on the use of a polyimide rather than a polyimide siloxane.

## TABLE II

### DIE STRESS MEASURED BY RADIUS OF CURVATURE R

### Die size 250 x 250 mil, standard lead frame

| Material | A | Conventional |
|---|---|---|
| R (mm) | 3950 | 311 |
| R (mm) (after annealing at 220°C) | 8860 | --- |

It will be noted that paste composition A gave a die radius of curvature value more than 10 times greater than the curvature value obtained with the conventional paste. This is equivalent to showing that die stress using the present paste is reduced to about one-tenth of that obtainable with the conventional paste.

Table II also shows that, after annealing, the stress value for the die attached with composition A was further substantially decreased. This is apparently due to the fact that the polyimide siloxane component is thermoplastic so that upon annealing at 200-230°C, stress relaxes substantially unlike the case with conventional polyimide which is thermosetting so that die stress increases when it is processed further at high temperature.

It appears that conventional pastes based on the use of polyimides or epoxies impart too much die stress because of their high modulus G. For example, a conventionally used polyimide and epoxy both have a modulus G (Kpsi) of 500-1000 whereas the polyimide siloxanes used herein have a modulus G (Kpsi) in the range of 125-145. It is also noted that polyimide siloxanes having a Tg significantly below 200, e.g. 125-150, have difficulty in passing reliability tests such as temperature cycling and thermal shock tests. The polyimide siloxanes used herein appear to have the appropriate combination of glass transition temperature (Tg) and low modulus (G) around 125-145 to give satisfactory and effective results on reliability tests as well as imparting very low stress on the die.

It will be appreciated that various modifications may be made in the invention as described herein. Hence, the scope of the claims is defined in the following claims wherein :

## Claims

1. A paste composition for die attachment comprising silver flake having a surface area between 0.4-1.3 $m^2/g$ and a tap density of from 2.5-4.0 g/cc ; a polyimide siloxane ; and a liquid vehicle having a boiling point in the range of 120-220°C.

2. The composition of claim 1 wherein the liquid vehicle is selected from the group consisting of acetophenone, diglyme, triglyme, 1-methyl 2-pyrrolidinone, acetyl acetone or mixtures thereof.

3. The composition of claim 2 wherein the polyimide siloxane is a block copolymer of hard imide segments and soft siloxane segments having a glass transition temperature greater than 200°C.

4. The composition of claim 3 wherein the polyimide siloxane has a modulus G (Kpsi) of around 125-145.

5. The composition of claim 3 containing 50-90% silver flake ; 7-20% polyimide siloxane, balance essentially vehicle

6. In a method of bonding a die to a substrate, the improvement which comprises using as the bonding medium, a composition according to claim 1.